# EUROPÄISCHE PATENTSCHRIFT

(11) **EP 1 862 046 B1**
(45) Veröffentlichungstag und Bekanntmachung des Hinweises auf die Patenterteilung: **15.04.2009**
(21) Anmeldenummer: 06705995.6
(22) Anmeldetag: 21.02.2006
(51) Int. Cl.: H05K 13/04

(54) **LINEARFÖRDERSYSTEM SOWIE VERFAHREN ZUM HOCHGENAUEN FÖRDERN VON KLEINEN BAUELEMENTEN**
LINEAR TRANSPORT SYSTEM AND METHOD FOR THE HIGHLY PRECISE TRANSPORT OF SMALL COMPONENTS
SYSTEME DE TRANSPORT LINEAIRE ET PROCEDE DE TRANSPORT TRES PRECIS DE PETITS COMPOSANTS

(30) Priorität: 19.03.2005 DE 102005012781; 15.04.2005 DE 102005017455
(43) Veröffentlichungstag der Anmeldung: 05.12.2007
(73) Patentinhaber: Meier, Peter, 93186 Neudorf (DE)
(72) Erfinder: Meier, Peter, 93186 Neudorf (DE)
(74) Vertreter: Glück, Martin
(86) Internationale Anmeldenummer: PCT/DE2006/000312
(87) Internationale Veröffentlichungsnummer: WO 2006/099832

(56) Entgegenhaltungen:
- DE-A1- 19 748 442

## Beschreibung

Die Erfindung betrifft ein Linearfördersystem gemäß dem Oberbegriff des Patentanspruches 1 sowie ein Verfahren gemäß dem Oberbegriff des Patentanspruches 13.

Fördersysteme zum Fördern von kleinen Bauelementen, insbesondere auch von kleinen elektrischen Bauelementen, beispielsweise auch in Form von SMDs (Surface Mounted Devices), sind in unterschiedlichsten Ausführungen bekannt und werden beispielsweise in Vorrichtungen oder Systemen verwendet, in denen derartige elektrische Bauelemente bearbeitet (z. B. Biegen von Anschlussdrähten); beschriftet, vermessen etc. werden und hierzu entlang einer Bearbeitungsstrecke beispielsweise schrittweise getaktet gefördert werden.

Aus der DE-Offenlegungsschrift 197 48 442 A1 ist beispielsweise ein derartiges Fördersystem zum Fördern von kleinen Bauelementen, vorzugsweise SMDs bekannt, das wenigstens eine Förderstrecke aufweist, die von einem ersten und einem zweiten Transportelement gebildet ist und die jeweils eine Vielzahl von Aufnahmebereichen zur Aufnahme und zum Halten jeweils eines Bauelementes besitzt. Ferner ist ein gemeinsamer Übergabebereich ausgebildet, an dem jedes Bauelement von einem Aufnahmebereich eines Transportelementes an einen Aufnahmebereich eines anderen Transportelementes weitergegeben wird, wobei die Aufnahmebereiche des einen Transportelementes als pipettenartige Vakuumhalter und die Aufnahmebereiche des anderen Transportelementes durch Öffnungen in einem Transportband oder im Transportrad dieses Transportelementes ausgebildet sind. Die als pipettenartige Vakuumhalter ausgebildeten Transportelemente sind an einem Stahlband vorgesehen, welches über zwei Umlenkrollen geführt wird. In zumindest einem der linearen Abschnitte der zwischen den beiden Umlenkrollen ausgebildeten Förderstrecke findet eine Bearbeitung der Bauelemente statt. Bei der beschriebenen Umwandlung der radialen Bewegung in eine lineare Bewegung entstehen jedoch Teilungsfehler, die ein hochgenaues lineares Fördern, beispielsweise mit einer Positioniergenauigkeit unter 0,01 mm nicht zulassen. Darüber hinaus ist die Positionierungsgenauigkeit insbesondere bei hohen Taktgeschwindigkeiten aufgrund der Elastizität des umlaufenden Stahlbandes deutlich reduziert. Ebenfalls nachteilig ist der Abstand der Aufnahmebereiche der Behandlungsmaschine an das Rastermaß der zum Zuführen der Bauelemente vorgesehenen Lead-Frames angepaßt, so dass die Verarbeitung von Lead-Frames unterschiedlichen Rastermaßes technisch aufwendige Umbauarbeiten erfordert.

Aufgabe der vorliegenden Erfindung ist es, ein Linearfördersystem zum hochgenauen Fördern von kleinen Bauelementen anzugeben, das die genannten Probleme vermeidet, d. h. ein lineares Fördern von Bauteilen mit einer Positioniergenauigkeit kleiner 0,1 mm ermöglicht. Zur Lösung dieser Aufgabe ist ein Linearfördersystem entsprechend dem Patentanspruch 1 und ein Verfahren entsprechend dem Patentanspruch 13 ausgebildet.

Der die Erfindung tragende Gedanke ist darin zu sehen, dass eingangsseitig eine ein Vorschubelement aufweisende Linearmotoreinheit zum linearen Antrieb der Förderschlittenelemente in Förderrichtung über das Vorschubelement vorgesehen ist. Darüber hinaus ist eine Rückführungseinheit zur Rückführung zumindest eines Förderschlittenelementes vom Ausgang zum Eingang der Förderstrecke vorgesehen, wobei die die Rückführungseinheit zum ausgangsseitigen Aushängen des zumindest einen den Entnahmebereich in Förderrichtung verlassenden Förderschlittenelementes aus der Förderschiene, zum Rückführen vom Ausgang zum Eingang über eine Rückführungsstrecke und zum eingangsseitigen Einhängen des zumindest einen rückgeführten Förderschlittenelementes in die Förderschiene ausgebildet ist. Das zumindest eine rückgeführte Förderschlittenelement wird hierbei in einen zwischen dem Vorschubelement der Linearmotoreinheit und dem Aufnahmebereich befindlichen Abschnitt der Förderschiene eingehängt. Vorteilhaft wird durch die präzise Führung der Förderschlittenelemente auf der Förderschiene sowie deren über die Linearmotoreinheit bzw. dessen Vorschubelement exakt steuerbarer Vorschub eine Reduzierung der Positioniergenauigkeit unter 0,01 mm erreicht. Vorteilhaft ist die Rückführung der am Ausgang der Förderstrecke ankommenden Förderschlittenelemente über einen getrennt von der Förderschiene vorgesehenen Rückführungsweg realisiert, wodurch eine Entkopplung der Rückführung von der eigentlichen Bearbeitung- bzw. Transportstrecke der Bauteile erzielt wird.

Nach einem weiteren Aspekt der Erfindung erfolgen das Ein- und das Aushängen des jeweiligen Förderschlittenelementes aus bzw. in die Förderschiene jeweils während einer Förderpause, wodurch eine Störung des schrittweisen Vorschubs der Förderschlittenelemente vermieden werden kann.

Weiterhin vorteilhaft erfolgt das Einhängen des rückgeführten Förderschlittenelementes in die Förderschiene unmittelbar nach dem Umschalten der Linearmotoreinheit von einem maximalen Auslenkzustand in einen minimalen Auslenkzustand und die für die Rückführung über die Rückführungsstrecke erforderliche Rückführungszeitdauer entspricht der von der Linearmotoreinheit für die Auslenkung des Vorschubelementes von der zum Aushängezeitpunkt vorliegenden Auslenkposition zum Erreichen des maximalen Auslenkungszustands erforderlichen Förderzeitdauer. Somit ist die Rückführung hinsichtlich der Rückführungsparameter Zeitdauer bzw. Rückführungsgeschwindigkeit sowie der ortsfesten Einhänge- bzw.
Aushängepositionen auf den jeweiligen Auslenkungszustand der Linearmotoreinheit angepasst. Besonders vorteilhaft werden die Rückführung und der Vorschub der Linearmotoreinheit über eine Steuereinheit gesteuert, welche beispielsweise zumindest eine Steuerroutine aufweist. Notwendige Änderungen der Steuerung des Linearfördersystems können somit schnell und kostengünstig softwaremäßig durchgeführt werden.

Vorteilhafte Weiterbildungen der Erfindung, insbesondere ein Verfahren zum hochgenauen Fördern von kleinen Bauelementen sind Gegenstand der weiteren Unteransprüche.

Die Erfindung wird im Folgenden anhand der Figuren an einem Ausführungsbeispiel näher erläutert. Es zeigen:
- Fig. 1: beispielhaft in schematischer Seitenansicht ein Linearfördersystem zum hochgenauen Fördern von kleinen Bauelementen gemäß der Erfindung zu vier unterschiedlichen Zeitpunkten t1 - t4,
- Fig.2: in vereinfachter Darstellung und im Längsschnitt entlang der Linie I - I einen Schnitt durch die Förderschiene sowie des darauf befindlichen Förderschlittenelementes gemäß Fig. 1,
- Fig. 3: beispielhaft in schematischer Draufsicht zwei aneinander anschließende Förderschlittenelemente und
- Fig. 4: beispielhaft in Draufsicht einen Ausschnitt eines Lead-Frames.

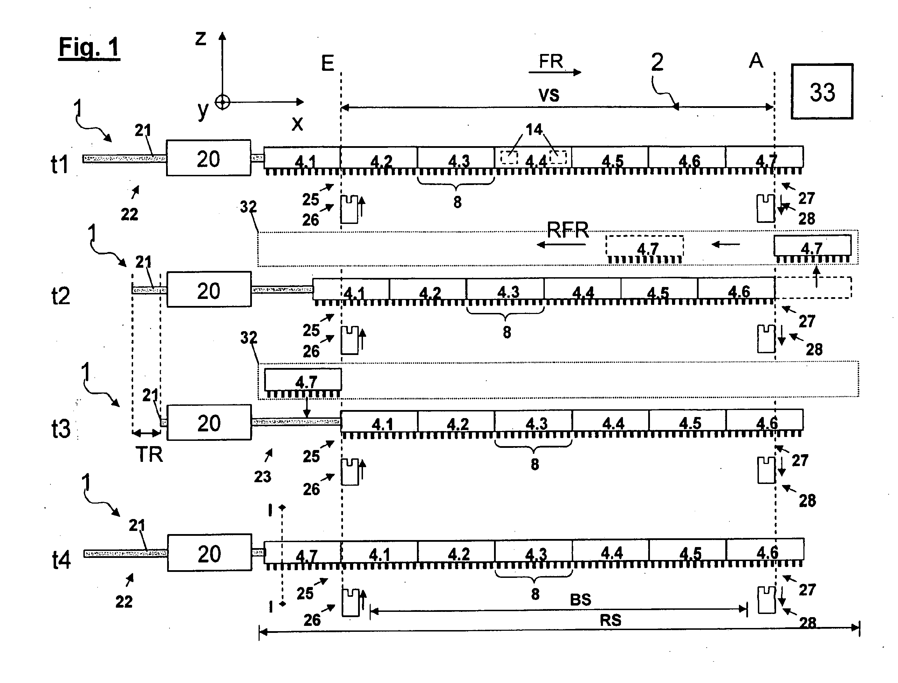

In Figur 1 ist ein Linearfördersystem 1 in einem schematischen Blockschaltbild dargestellt, das eine Förderstrecke 2 zum Fördern von Bauelementen 3, insbesondere von elektronischen Bauelementen, beispielsweise von SMDs (Surface Mounted Devices) aufweist. Die Förderstrecke 2 besteht aus mehreren, aneinander anschließenden Förderschlittenelementen 4, welche auf einer Förderschiene 5 beweglich gelagert sind und erstreckt sich in Förderrichtung FR von einem Eingang E zu einem Ausgang A. Die Förderrichtung FR verläuft hierbei in positiver x-Richtung eines durch die jeweils senkrecht zueinander verlaufenden Raumachsen, d.h. x-Achse x, y- Achse y sowie z-Achse z aufgespannten dreidimensionalen Raumes.

Bei dem in Figur 1 dargestellten Ausführungsbeispiel ist die Förderstrecke 2 durch ein erstes bis siebtes Förderschlittenelement 4.1 bis 4.7 gebildet, welche in Serie in Förderrichtung FR bzw. in Richtung der x-Achse x aneinander anschließend angeordnet und auf der Förderschiene 5 beweglich gelagert sind. An das eingangsseitig vorgesehene erste Förderschlittenelement 4.1 schließt sich das zweite Förderschlittenelement 4.2, gefolgt von dem dritten Förderschlittenelement 4.3 an. An das dritte Förderschlittenelement 4.3 schließ sich das vierte Förderschlittenelement 4.4 an, dem das fünfte Förderschlittenelement 4.5 nachgeführt ist. Dem fünften Förderschlittenelement 4.5 folgt das sechste Förderschlittenelement 4.6 und diesem das siebte Förderschlittenelement 4.7.

In einer bevorzugten Ausführungsform weisen das erste bis siebte Förderschlittenelement 4.1 bis 4.7 jeweils dieselbe Länge und an zumindest einer Ihrer Stirnseite - vorzugsweise der in Förderrichtung FR weisenden Stirnseite - jeweils ein Abstandelement 24 auf, welches von der Stirnseite jeweils senkrecht in Richtung der x-Achse wegsteht und jeweils an der vom Abstandselement 24 gegenüberliegenden Stirnseite des folgenden Förderschlittenelements 4.1 bis 4.7 anliegt. Die Abstandselemente 24 weisen jeweils einen im Vergleich zu den Stirnseiten der Förderschlittenelemente 4.1 bis 4.7 deutlich reduzierten Flächeninhalt auf, um hierdurch ein Abweichen der Gesamtlänge der Förderstrecke 2 aufgrund von sich auf den Stirnflächen bildenden Verschmutzung bzw. Staubresten zwischen zwei aneinander anliegenden Förderschlittenelementen 4.1 bis 4.7 zu verhindern und somit die Positioniergenauigkeit des Linearförderers 1 zu erhöhen.

Ein derartiges Förderschlittenelement 4 weist jeweils mehrere Transportelemente 8 auf, welche vorzugsweise als auf einer Pipettenträgerleiste 6 angeordnete Pipettenhalter 8 ausgebildet sind. Die Pipettenträgerleiste 6 ist hierzu parallel zur x-Achse x, d.h. in Förderrichtung FR angeordnet, weist mehrere senkrecht zur Förderrichtung FR bzw. parallel zur z-Achse z angeordnete Ausnehmungen 7 auf, in denen jeweils ein Pipettenhalter 8 vorzugsweise verdrehungssicher vorgesehen ist. Die Ausnehmungen 7 weisen beispielsweise einen Durchmesser von 3 bis 7 mm, vorzugsweise 5 mm auf und sind in einem Abstand von ca. 3 bis 10 mm, vorzugsweise ebenfalls 5 mm zueinander angeordnet. Pro Pipettenträgerleiste 6 bzw. pro Förderschlittenelement 4 können beispielsweise zwischen 30 und 40 Pipettenhalter 8 vorgesehen sein, so dass sich für ein Förderschlittenelement 4 eine Gesamtlänge bzw. Erstreckung entlang der x-Achse x von 180 bis 560 mm, vorzugsweise 250 mm ergibt. Die Ausnehmungen 7 sind hierbei beispielsweise zylinderförmig ausgebildet.

Ein Pipettenhalter 8 ist in einer bevorzugten Ausführungsform als Vakuum-Pipettenhalter ausgebildet, welcher in vertikaler Richtung, d.h. entlang der z-Achse z verschiebbar in der Pipettenträgerleiste 6 gehalten wird. Der Pipettenhalter 8 weist einen aus der Pipettenträgerleiste 6 nach oben herausragenden oberen Teil 8.1, einen von der Pipettenträgerleiste 6 umschlossenen mittleren Teil 8.2 sowie einen von der Pipettenträgerleiste 6 in negativer z-Richtung weg stehenden unteren Teil 8.3 auf.

Entlang der parallel zur z-Achse z verlaufenden Längsachse LA des Pipettenhalters 8 erstreckt sich im Inneren des Pipettenhalters 8 ein Vakuumkanal 9, der zumindest im oberen und mittleren Teil 8.1, 8.2 des Pipettenhalters 8 einen ersten Durchmesser D1 aufweist. In einem Übergangsbereich 10 zwischen dem mittleren und unteren Teil 8.2, 8.3 des Pipettenhalters 8 läuft der Vakuumkanal 9 trichterförmig nach unten zu und nimmt einen zweiten Durchmesser D2 an, der beispielsweise der Hälfte oder einem Drittel des ersten Durchmessers D1 entspricht.

Der Vakuumkanal 9 weist ferner am oberen Teil 8.1 des Pipettenhalters 8 ein oberes offenes Ende 9.1 auf, welches mit einem Deckel 11 zum luftdichten Verschluss des Vakuumkanals 9 versehen ist. Das dem oberen offenen Ende 9.1 gegenüberliegende, im Bereich des unteren Teils 8.3 des Pipettenhalters 8 vorgesehene untere offene Ende 9.2 des Vakuumkanals 9 ist unverschlossen und bildet somit eine Ansaugöffnung zur Aufnahme zumindest eines Bauelementes 3 aus, welches somit durch den im Vakuumkanal 9 erzeugten Unterdruck am unteren offenen Ende 9.2 des Vakuumkanals 9 angesaugt wird und aufgrund des im Vakuumkanal 9 fortbestehenden Vakuums bzw. Unterdrucks an der Ansaugöffnung 9.2 gehalten wird.

Über eine runde oder langlochförmige Durchlassöffnung 12 im oberen Teil 8.1 des Pipettenhalters 8 ist der Vakuumkanal 9 mit einer Vakuumführungsöffnung 13 der Pipettenträgerleiste 6 verbunden, wobei der Durchmesser D3 bzw. die Erstreckung entlang der Längsachse LA der Durchlassöffnung 12 zur Verschiebung des Pipettenhalters 8 parallel zur z-Achse z derart ausgebildet ist, daß auch bei einem vollständig in die Ausnehmung 7 der Pipettenträgerleiste 6 eingeschobenen Pipettenhalter 8 jeweils eine ausreichend große Öffnung zwischen der Vakuumführungsöffnung 13 der Pipettenträgerleiste 6 und dem Vakuumkanal 9 des Pipettenhalters 8 fortbesteht, um hierdurch auch bei ausgefahrenem Pipettenhalter 8 das im Vakuumkanal 9 vorliegende Vakuum aufrechtzuerhalten.

Ferner ist der Pipettenhalter 8 über eine zwischen dem Deckel 11 und der Oberfläche der Pipettenträgerleiste 6 vorgesehene Druckfeder 18 vorgespannt, welche im genannten Bereich den oberen Teil 8.1 des Pipettenhalters 8 umgibt. Aufgrund der in positive z-Richtung wirkenden Federkraft wird ein in negativer z-Richtung ausgelenkter Pipettenhalter 8 nach oben zurückgefedert, und zwar bis ein im unteren Teil 8.3 einstückig mit dem Pipettenhalter 8 ausgebildeter Anschlagring 19, der einen größeren Außendurchmesser als die Ausnehmung 7 aufweist, an der Bodenfläche der Pipettenträgerleiste 6 anschlägt.

An der senkrecht zur γ-Achse y verlaufenen Seitenfläche der Pipettenträgerleiste 6 sind pro Förderschlittenelement 4 jeweils mindestens zwei Kugelumlaufschlittenelemente 14 vorgesehen, welche jeweils über ein erstes und zweites, in Förderrichtung FR verlaufendes Kugellager 14.1, 14.2 verfügen, welche zur beweglichen Lagerung der Kugelumlaufschlittenelemente 14 in Förderrichtung FR vorgesehen sind. Hierzu sind die Kugeln des ersten und zweiten Kugellagers 14.1, 14.2 jeweils entlang einer Parallelen zur x-Achse x angeordnet und werden über einen ersten und zweiten Kugelsicherungsbügel 14.3, 14.4 am Kugelumlaufschlittenelement 14 gehalten, der beim Abziehen des Kugelumlaufschlittenelementes 14 von der Förderschiene 5 einen Kugelverlust verhindert.

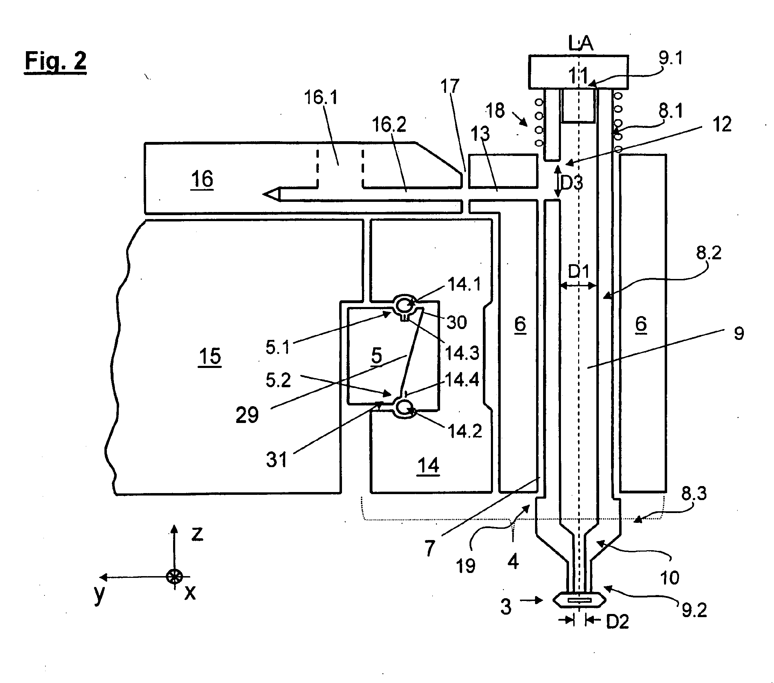

Die Kugeln des ersten und zweiten Kugellagers 14.1, 14.2 der beiden Kugelumlaufschlittenelemente 14 werden in einer ersten und zweiten Ausnehmung bzw. Führungsschiene 5.1, 5.2 der Förderschiene 5 gehalten, die jeweils zur Aufnahme des ersten und zweiten Kugellagers 14.1, 14.2 bzw. des ersten und zweiten Kugelsicherungsbügels 14.3, 14.4 angepasst sind und ein spielfreies Gleiten der Kugelumlaufschlittenelemente 14 und somit des auf diesen angeordneten Förderschlittenelementes 4 auf der Förderschiene 5 ermöglichen. Die Förderschiene 5 ist hierzu auf einer Grundblockeinheit 15 angeordnet, welche in Figur 2 lediglich ausschnittsweise dargestellt ist und sich über die gesamte Länge der Förderstrecke 2 erstreckt. Die Förderschiene 5 ist auf der in negativer y-Richtung weisenden Seitenfläche der Grundblockeinheit 15 angeordnet, und zwar derart, dass die erste und zweite Ausnehmung 5.1, 5.2 in einer parallel zu der durch die x- und z-Achse x, z aufgespannten Ebene verlaufen.

Auf der senkrecht zur z-Achse z verlaufenden Oberfläche der Grundblockeinheit 15 ist eine Vakuumversorgungsschiene 16 vorgesehen, welche sich ebenfalls in Förderrichtung FR erstreckt und zwar vom Eingang E bis zum Ausgang A der Förderstrecke 2. Die Vakuumversorgungsschiene 16 weist zumindest eine Vakuumanschlussöffnung 16.1 auf, die parallel zur z-Achse z und somit parallel zur Längsachse LA von der Oberfläche der Vakuumversorgungsschiene 16 bis zu einer Vakuumversorgungsausnehmung 16.2 sich erstreckt. Die Vakuumversorgungsausnehmung 16.2 ist in einer parallel zu der durch die x- und y-Achse x, y aufgespannten Ebene vorgesehen und bildet einen in Förderrichtung FR verlaufenden, quaderförmigen Kanal aus, der sich entlang des unteren Bereiches der Vakuumversorgungsschiene 16 auf Höhe der auf den Kugelumlaufschlittenelementen 14 angeordneten Pipettenträgerleiste 6 bzw. dessen Vakuumführungsöffnung 13 erstreckt. Die Vakuumversorgungsausnehmung 16.2 wirkt mit der Vakuumführungsöffnung 13 zur Ausbildung eines geschlossenen Vakuumführungskanals zwischen der Vakuumanschlussöffnung 16.1 und dem Vakuumkanal 9 des Pipettenhalters 8 zusammen, so dass sich das zum Ansaugen der Bauelemente 3 erforderliche Vakuum im Vakuumkanal 9 ausbildet. Die Pipettenträgerleiste 6 weist beispielsweise einen den Übergangsbereich zwischen oberem Teil 8.1 und mittlerem Teil 8.2 der Pipettenhalter 8 umgebenden Abschnitt auf, der beispielsweise in positiver y-Richtung y, d.h. in Richtung der Grundbtockeinheit 15 weg steht und unmittelbar mit der anschließenden Vakuumversorgungsschiene 16 in Verbindung steht. Insbesondere weist der zwischen dem genannten Abschnitt der Pipettenträgerleiste 6 und der daran anschließenden Vakuumversorgungsschiene 16 gebildete Spalt 17 zur Ausbildung des Unterdrucks im Vakuumkanal 9 der Pipettenhalter 8 eine maximale Breite von ca. 0,01 mm auf.

Das erfindungsgemäße Linearfördersystem 1 zum Fördern von kleinen elektronischen Bauelementen 3 ermöglicht ein hochgenaues, vorzugsweise schrittweise getaktetes Fördern entlang einer linear verlaufenden Förderstrecke 2 mit Hilfe einer Linearfördereinheit 20, welche hierzu ein in Förderrichtung FR verlaufendes Vorschubelement 21 aufweist. Derartige Linearfördereinheiten 20 sind an sich bekannt und sind beispielsweise über unterschiedliche beispielsweise softwarebasierte Steuerroutinen ansteuerbar. Bevorzugt werden zum Antrieb der Förderstrecke 2 Linearfördereinheiten 20 eingesetzt, welche beispielsweise eine Auflösung kleiner 0,001 mm aufweisen. Das Vorschubelement 21 ist durch Ansteuerung der Linearmotoreinheit 20 schrittweise, vorzugsweise getaktet in x-Richtung bzw. in Förderrichtung FR von einem minimalen Auslenkzustand 22 in einen maximalen Auslenkzustand 23 auslenkbar, wobei zwischen dem minimalen und maximalen Auslenkzustand 22, 23 eine Vielzahl von unterschiedlichen Auslenkpositionen schrittweise anfahrbar sind. Durch das beispielsweise schrittweise, vorzugsweise getaktete Ausfahren des Vorschubelements 21 aus der Linearmotoreinheit 20 in Förderrichtung FR entsteht jeweils zwischen zwei Vorschubschritten eine Förderpause.

In Fig. 1 ist beispielhaft ein Linearfördersystem 1 mit sieben Förderschlittenelementen 4.1 bis 4.7 zu einem ersten bis vierten Förderzeitpunkt t1 bis t4 dargestellt. Im ersten Förderzeitpunkt t1 weist die Linearmotoreinheit 20 den minimalen Auslenkzustand 22 auf, bei dem das Vorschubelement 21 nahezu vollständig in der Linearmotoreinheit 20 eingefahren ist, d.h. die in Förderrichtung FR gerichtete Auslenkung des Vorschubelements 21 ist minimal. Im dargestellten Ausführungsbeispiel schließt das stirnseitige in Förderrichtung FR gerichtete Ende des Vorschubelements 21 an der Stirnseite des ersten Förderschlittenelementes 4.1 an und ist somit mit diesem antriebsmäßig verbunden. Hierbei ist das erste Förderschlittenelement 4.1 zwar bereits auf die Förderschiene 5 aufgesetzt, steht jedoch noch nicht über die Vakuumführungsöffnung 13 in Verbindung mit der Vakuumsversorgungsschiene 16.

Am Eingang E der Förderstrecke 2 ist ein Aufnahmebereich 25 vorgesehen, in dem unterhalb der Förderstrecke 2 eine Aufnahmeeinheit 26 angeordnet ist, welche die Bauelemente 3 unterhalb der Ansaugöffnung 9.2 eines Pipettenhalters 8 des jeweiligen Förderschlittenelementes 4 fördert. Der zu bestückende Pipettenhalter 8 befindet sich somit senkrecht oberhalb der Aufnahmeeinheit 26. Über die Vakuumversorgungsschiene 16 wird zwischen dem Eingang E und dem Ausgang A eine Vakuumstrecke VS ausgebildet, die in etwa der Länge der Vakuumversorgungsschiene 16 entspricht und über die in den Pipettenhaltern 8 der auf der Vakuumstrecke VS befindlichen Förderschlittenelemente 4.1 bis 4.7 ein Unterdruck erzeugt wird.

Die jeweils über die Druckfeder 18 in positiver z-Richtung in der Pipettenträgerleiste 6 vorgespannten Pipettenhalter 8 sind beispielsweise über eine ortsfeste Führungskurve - nicht in den Figuren dargestellt - hinsichtlich ihrer vertikalen Auslenkung parallel zur z-Achse z steuerbar. Ein zur Aufnahme eines Bauelementes 3 mit der Vakuumversorgungsschiene 16 verbundener Pipettenhalter 8 wird im Aufnahmebereich 25 über die ortsfeste Führungskurve vertikal nach unten gesteuert und nimmt aufgrund des im Vakuumkanal 9 ausgebildeten Unterdrucks, der über die Ansaugöffnung 9.2 nach außen wirkt, das auf der Aufnahmeeinheit 26 befindliche Bauelement 3 auf, wobei beispielsweise der Ansaugvorgang zwischen zwei Vorschubschritten, d. h. in einer Förderpause der Förderschlittenelemente 4 auf der Förderstrecke 2 erfolgen kann.

Zwischen dem Eingang E und dem Ausgang A erstreckt sich die Bearbeitungsstrecke BS, auf der die an dem Pipettenhalter 8 befindlichen Bauelemente 3 einem oder mehreren Bearbeitungsvorgängen, beispielsweise Messen, Beschriften, Biegen etc. unterzogen werden. Hierzu weist das in den Figuren dargestellte Linearfördersystem 1 eine Positioniergenauigkeit kleiner 0,01 mm auf, wobei die Bearbeitungsdauer für ein einzelnes Bauelement 3 zwischen 200 - 300 Millisekunden gewählt werden kann und die zwischen zwei Fördertakten liegende Förderpause ca. 250 Millisekunden aufweist.

Nach erfolgter Bearbeitung werden die an dem Pipettenhalter 8 gehaltenen Bauelemente 3 einem Entnahmebereich 27, welcher beispielsweise am Ausgang E der Förderstrecke 2 vorgesehen ist, zugeführt. Im Entnahmebereich 27 ist hierzu die in Figur 1 schematisch dargestellte Entnahmeeinheit 28 vorgesehen, welche zur Entnahme der bearbeiteten Bauelemente 3 von dem darüber befindlichen Pipettenhalter 8 vorgesehen ist.

Die Entnahmeeinheit 28 ist hierzu - analog zur Aufnahmeeinheit 26 - vertikal unterhalb der Förderstrecke 2 des Linearfördersystems 1 vorgesehen. Gesteuert über eine weitere ortsfeste Führungskurve werden die über die Druckfeder 18 vorgespannten Pipettenhalter 8 senkrecht nach unten, d.h. in negativer z-Richtung geführt, so dass sich die an der Pipettenhalterspitze 8.3 befindlichen bearbeiteten Bauelemente 3 unmittelbar über der Entnahmeeinheit 28 befinden. Zur Entnahme eines bearbeiteten Bauelementes 3 von dem unteren offenen Ende 9.2 des Pipettenhalters 8 wird im Pipettenhalter 8 beispielsweise ein Überdruck erzeugt und somit das bearbeitete Bauelement in Richtung der Entnahmeeinheit 28 geführt. Alternativ kann eine Abstreifeinheit vorgesehen sein, welche das bearbeitete Bauelement 3 von dem unteren offenen Ende 9.2 des Pipettenhalters 8 abstreift und dieses der Entnahmeeinheit 28 zuführt. Dieses wird durch die Entnahmeeinheit 28 aufgenommen und beispielsweise in die Öffnung eines Blistertapes abgelegt.

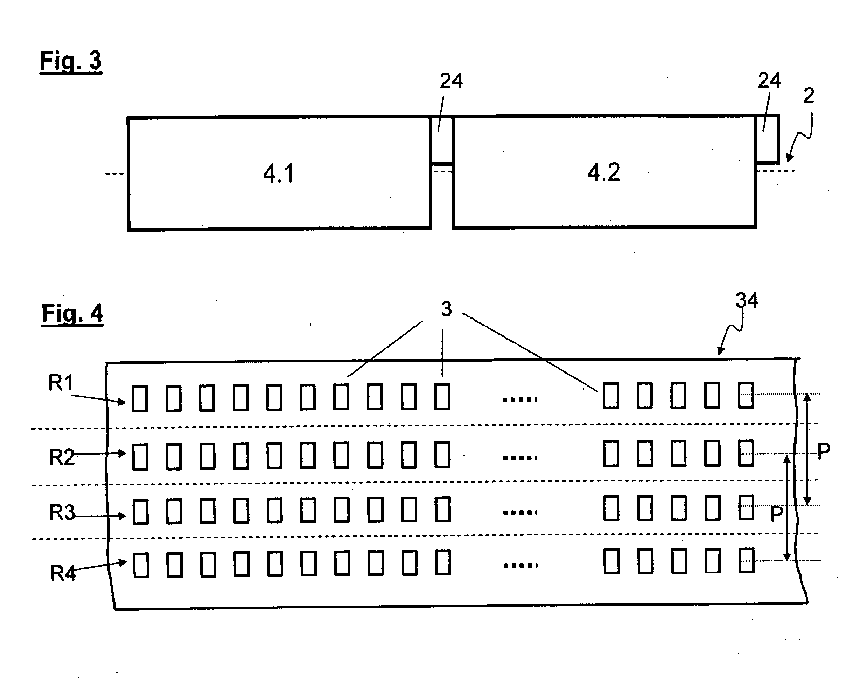

An die Aufnahmeeinheit 26 können die unbearbeiteten Bauelemente 3 beispielsweise über einen Lead-Frame 34 zugeführt und von der Entnahmeeinheit 28 beispielsweise über eine Blistertape abgeführt werden. Ein derartiger Lead-Frame 34 kann beispielsweise als vierfach Lead-Frame 34 ausgebildet sein, d.h. auf diesem Lead-Frame 34 sind Bauelemente 3 in vier sich jeweils in Lead-Frame-Längsrichtung erstreckende Reihen angeordnet. In Figur 4 ist beispielhaft ein vierfacher Lead-Frame 34 dargestellt, dessen Bauelemente 3 eine erste bis vierte Reihe R1 - R4 bilden. Die Bauelemente 3 jeder Reihe R1 bis R4 sind jeweils in Lead-Frame-Querrichtung, d.h. parallel zur Förderrichtung FR achsgleich zueinander angeordnet. Der Abstand P zwischen den beiden jeweils gemeinsam verarbeiteten Reihen R1/R3, R2/R4 gibt hierbei das Rastermaß des jeweiligen Lead-Frames 34 an und entspricht in etwa dem Achsabstand zweier an der Pipettenträgerleiste 6 gehaltenen, aufeinander folgenden Pipettenhalter 8 bzw. dem Abstand deren Ansaugöffnungen 9.2.

Die Aufnahmeeinheit 26 sowie die Entnahmeeinheit 28 sind ortsfest mit der Förderstrecke 2 verbunden, so dass die Aufnahme bzw. Entnahme von Bauelementen 3 durch das schrittweise Ausfahren des Vorschubelementes 21 der Linearmotoreinheit 20 in Förderrichtung FR erfolgt, und zwar durch beispielsweise getaktetes Fördern des ersten bis siebten Förderschlittenelementes 4.1 bis 4.7 entlang der Förderschiene 5.

Das zum ersten Förderzeitpunkt t1 im Entnahmebereich 27 der Förderstrecke 2 befindliche siebte Förderschlittenelement 4.7 ist zumindest teilweise noch mit Bauteilen 3 bestückt, welche an den innerhalb der Vakuumstrecke VS befindlichen Pipettenhaltern 8 des siebten Förderschlittenelementes 4.7 gehalten werden. Gleichzeitig weist das den Anfang der Förderstrecke 2 bildende erste Förderschlittenelement 4.1 aufgrund der den minimalen Auslenkzustand 22 aufweisenden Linearmotoreinheit 20 den innerhalb des Linearfördersystems 1 geringsten möglichen Abstand von der Linearmotoreinheit 20 auf, d.h. mit den folgenden schrittweisen Vorschüben in x- Richtung nimmt der Abstand des ersten Förderschlittenelements 4.1 von der Linearmotoreinheit 20 laufend zu. Insbesondere steht das erste Förderschlittenelement 4.1 zum ersten Zeitpunkt t1 unmittelbar vor seinem Eintritt in die Vakuumstrecke VS bzw. den Aufnahmebereich 25, in dem sich zum genannten Zeitpunkt noch das der Linearmotoreinheit 20 zugewandte Ende des zweiten Förderschlittenelementes 4.2 befindet.

Durch das schrittweise, beispielsweise über eine softwarebasierte Steuerroutine gesteuerte Ausfahren des Vorschubelementes 21 der Linearmotoreinheit 20 wird nunmehr das erste Förderschlittenelement 4.1 bzw. die an dieses anschließenden weiteren Förderschlittenelemente 4.2 bis 4.7 auf der Förderschiene 5 in Förderrichtung FR geschoben. Zu einem zweiten Förderzeitpunkt t2 ist das siebte Förderschlittenelement 4.7 aus dem Entnahmebereich 27 in Förderrichtung FR gefördert und somit vollständig von der Vakuumversorgungsschiene 13 entkoppelt. Allerdings befindet sich das zum zweiten Förderzeitpunkt t2 zumindest teilweise bereits mit Bauelementen 3 bestückte erste Förderschlittenelement 4.1 noch teilweise am Anfang der Vakuumstrecke VS des Linearfördersystems 1, d.h. zur vollständigen Bestückung mit Bauelementen ist noch eine Vielzahl von Vorschubschritten der Linearmotoreinheit 20 erforderlich, nämlich die zum Erreichen des maximalen Auslenkzustandes 23 erforderliche Anzahl an Vorschubschritten.

Nach Verlassen des Entnahmebereiches 27 durch das siebte Förderschlittenelement 4.7 und der damit verbundenen Entkopplung von der Vakuumversorgungsschiene 16 wird das siebte Förderschlittenelement 4.7 aus der Förderschiene 5 durch eine Rückführungseinheit 32 vertikal nach oben, d.h. in einer parallel zur z-Achse z verlaufenden Richtung entnommen, wobei die Abkopplung des siebten Förderschlittenelementes 4.7 bevorzugt zwischen zwei aufeinander folgenden Vorschubschritten, d.h. in einer Förderpause erfolgt. Hierdurch wird ein störungsfreies Entkoppeln des siebten Förderschlittenelementes 4.7 von den übrigen auf der Förderschiene 5 befindlichen Förderschlittenelementen 4.1 bis 4.6 gewährleistet.

Im Anschluss wird das aus der Förderschiene 5 ausgehängte siebte Förderschlittenelement 4.7 beispielsweise entlang einer parallel zur Förderstrecke 2 vorgesehenen Rückführungsstrecke RS in Rückführungsrichtung RFR zum Eingang E der Förderstrecke 2 rückgeführt.

Die Rückführung des siebten Förderschlittenelementes 4.7 kann hierbei anhand unterschiedlich geführter Rückführungsstrecken RS sowie unterschiedlichen Rückführungsgeschwindigkeiten erfolgen, maßgeblich hierbei ist, dass die für die Rückführung erforderliche Rückführungszeitdauer TR derart gewählt ist, dass zum Zeitpunkt der Ankunft des siebten Führungsschlittenelementes 4.7 am Eingang E der Förderstrecke 2 das Vorschubelement 21 der Linearmotoreinheit 20 nahezu vollständig ausgefahren ist, d.h. den maximalen Auslenkzustand 22 aufweist. Somit entspricht die für die Rückführung über die Rückführungsstrecke RS erforderliche Rückführungszeitdauer TR der von der Linearmotoreinheit 20 für die Auslenkung des Vorschubelementes 21 von der zum Aushängezeitpunkt vorliegenden Auslenkposition zum Erreichen des maximalen Auslenkungszustands 23 erforderlichen Förderzeitdauer.

Der in Figur 1 dargestellte zweite Förderzeitpunkt t2 stellt eine Momentaufnahme des Linearfördersystems 1 zum Beginn der Rückführungszeitdauer TR, d.h. zum Aushängezeitpunkt dar und der ebenfalls in Figur 1 dargestellte dritte Förderzeitpunkt t3 zeigt das Linearfördersystem 1 am Ende der Rückführungszeitdauer TR. Zum dritten Förderzeitpunkt t3 befindet sich das erste Förderschlittenelement 4.1 vollständig auf der Vakuumstrecke VS und gewährleistet somit einen nahtlosen Anschluss des rückgeführten siebten Förderschlittenelementes 4.7 an das erste Förderschlittenelement 4.1. Das sechste Förderschlittenelement 4.6 befindet sich zum dritten Förderzeitpunkt t3 - analog zum siebten Förderschlittenelement 4.7 im ersten Förderzeitpunkt t1 - ausgangsseitig zumindest teilweise außerhalb der Vakuumstrecke VS.

Das Einhängen des rückgeführten Förderschlittenelementes 4.7 in die Förderschiene 5 erfolgt unmittelbar nach dem Umschalten der Linearmotoreinheit 20 von dem maximalen Auslenkzustand 23 in den minimalen Auslenkzustand 22 und wird bevorzugt wiederum während einer Förderpause, d. h. zwischen zwei Vorschubschritten durchgeführt, um einen nahtlosen Anschluss ohne Beeinträchtigung der Führung der auf der Führungsschiene 5 befindlichen ersten bis sechsten Förderschlittenelemente 4.1 bis 4.6 sicherzustellen.

Durch das im Übergang vom dritten zum vierten Förderzeitpunkt t3, t4 erfolgte Umschalten der Linearmotoreinheit 20 von dem maximalen Auslenkzustand 23 in den minimalen Auslenkzustand 22 wird das zum dritten Zeitpunkt t3 zwischen Förderschiene 5 und dem rückgeführten siebten Förderschlittenelement 4.7 befindliche Vorschubelement 21 nahezu vollständig in die Linearmotoreinheit 20 eingefahren. Der nun frei werdende Abschnitt der Förderschiene 5 zwischen dem Vorschubelement 21 der Linearmotoreinheit 20 und dem der Linearmotoreinheit 20 zugewandten Ende des ersten Förderschlittenelementes 4.1 entspricht in etwa der Länge des einzuhängenden siebten Förderschlittenelementes 4.7, weist jedoch noch keine Überlappung mit der Vakuumversorgungsschiene 16 auf.

Im Übergang vom dritten zum vierten Förderzeitpunkt t3, t4 wird nun das siebte rückgeführte siebte Förderschlittenelement 4.7 in einer Förderpause in die Förderschiene 5 eingehängt und im folgenden Vorschub des Vorschubelements 21 eine Verbindung zwischen dem siebten und dem ersten Förderschlittenelement 4.7, 4.1 hergestellt. Das Umschalten der Linearmotoreinheit 20 sowie das Einhängen in den aufgrund des Umschaltens frei werden Abschnitt der Förderschiene 5 erfolgt bevorzugt in einer gemeinsamen Förderpause.

Die Förderstrecke weist nun wiederum sämtliche Förderschlittenelemente 4.1 bis 4.7 auf, die zum Fördern der Bauelemente 3 aneinander anliegend beispielsweise schrittweise in Förderrichtung FR geschoben werden.

Analog zu den in Fig. 1 dargestellten Momentaufnahmen des Linearfördersystems 1 zu vier unterschiedlichen aufeinander folgenden Förderzeitpunkten t1 bis t4 wird jedes bis zum Ausgang A der Förderstrecke 2 geförderte Förderschlittenelement 4.1 bis 4.7 nach vollständigem Verlassen des Entnahmebereiches 27 über die Rückführungseinheit 32 zum Eingang E der Förderstrecke 2 rückgeführt, so dass ein fortlaufender aus einer Förderphase und einer Rückführphase bestehender Förderzyklus entsteht, der sich im Betrieb des Linearfördersystems 1 ständig wiederholt.

Zum erleichterten Ein- und Aushängen der Förderschlittenelemente 4.1 bis 4.7 in bzw. aus der Förderschiene 5 weist diese eingangsseitig vor dem Aufnahmebereich 25 sowie ausgangsseitig nach dem Entnahmebereich 27, d.h. am Aushänge- bzw. Einhängeort eine dem Kugelumlaufschlittenelement 14 zugewandte Außenseite 29 auf, die abgeschrägt ist, und zwar derart, dass der Abstand der Außenseite 29 von der durch die x- und z-Achse x, z aufgespannten Ebene in negativer z-Richtung abnimmt.

Die erste Ausnehmung 5.1 der Förderschiene 5 ist im Querschnitt halbkreisförmig ausgebildet und weist einen sich an die halbkreisförmige Ausnehmung anschließenden Steg 30 auf, der ein seitliches Ausbrechen des in der ersten Ausnehmung 5.1 geführten ersten Kugellagers14.1 und somit des Kugelumlaufschlittenelementes 14 in negativer y-Richtung aus der ersten Ausnehmung 5.1 verhindert. Analog hierzu ist die zweite Ausnehmung 5.2 der Förderschiene 5 im Bereich der Vakuumstrecke VS, jedoch spiegelbildlich hierzu, ausgebildet.

Durch die Abschrägung der Außenseite 29 der Förderschiene 5 an dem jeweiligen Aushänge- bzw. Einhängeort entfällt bei der ansonsten symmetrisch zur ersten Ausnehmung 5.1 ausgebildeten zweiten Ausnehmung 5.2 somit der Steg 30. Durch die über Materialentnahme erfolgte Reduzierung stellt die zweite Ausnehmung 5.2 somit im Querschnitt lediglich eine beispielsweise viertelkreisförmige Abfräsung des Eckbereiches 31 der Förderschiene 5 dar, die aufgrund des dadurch fehlenden Stegs 30 ein Einführen des zweiten Kugellagers 14.2. des Kugelumlaufschlittenelementes 14 in die Förderschiene 5 schnell und zuverlässig ermöglicht. Somit können das zweite Kugellager 14.2 sowie dessen zweiter Kugelsicherungsbügel 14.4 der Kugelumlaufschlittenelemente 14 eines Förderschlittenelementes 4 ungehindert ein- und ausgehängt werden.

In einer bevorzugten Ausführungsform des Linearfördersystems 1 weist die Vakuumversorgungsschiene 16 bzw. die Vakuumstrecke VS eine Länge von ca. 1000 - 1500 mm, vorzugsweise 1300 mm auf und erstreckt sich vom Aufnahmebereich 25 bis zum Entnahmebereich 27.

Ferner weist das Linearfördersystem 1 eine Steuereinheit 33 auf, die zur Steuerung der Linearmotoreinheit 20 und/oder der Rückführungseinheit 32 vorgesehen ist. Über in der Steuereinheit 33 ablaufende softwarebasierte Steuerroutinen können sämtliche Funktionen der Linearmotoreinheit 20 und/oder der Rückführungseinheit 32 und/oder der Aufnahmeeinheit 26 sowie der Entnahmeeinheit 28 gemeinsam oder getrennt voneinander gesteuert werden. Darüber hinaus ermöglichen derartige softwarebasierte Steuerroutinen eine schnelle Anpassung des Linearfördersystems 1, beispielsweise an unterschiedliche Dimensionierung der zu fördernden elektronischen Bauelemente 3. So kann beispielsweise anhand einer einfachen Umprogrammierung der Steuerroutine der Takt der Vorschubschritte bzw. deren Schrittweise oder auch Geschwindigkeit bedarfsgerecht eingestellt werden.

Auch ist beispielsweise die Verwendung von eine unterschiedliche Länge oder einen unterschiedlichen Pipettenhalterabstand aufweisenden Förderschlittenelementen innerhalb desselben Linearfördersystems 1 durch eine einfache softwaremässige Anpassung der Steuerroutinen, insbesondere für die Linearmotoreinheit 20 sowie die Rückführungseinheit 32, möglich. Somit können auch Lead-Frames 34 mit einem unterschiedlichen Rastermaß P durch die Verwendung von an das Rastermaß angepassten Förderschlittenelementen und über eine Anpassung der Softwareroutinen der Steuereinheit 33 schnell und mit geringen technischen Modifikationen verwendet werden.

Die Erfindung wurde voranstehend an Ausführungsbeispielen beschrieben, es versteht sich, dass zahlreiche Änderungen sowie Modifikationen möglich sind, ohne dass damit der der Erfindung zugrunde liegende Erfindungsgedanke verlassen wird.

### Bezugszeichenliste

- 1: Linearförderer
- 2: Förderstrecke
- 3: Bauelement(e)
- 4: Förderschlittenelement(e)
- 4.1: erstes Förderschlittenelement
- 4.2: zweites Förderschlittenelement
- 4.3: drittes Förderschlittenelement
- 4.4: viertes Förderschlittenelement
- 4.5: fünftes Förderschlittenelement
- 4.6: sechstes Förderschlittenelement
- 4.7: siebtes Förderschlittenelement
- 5: Förderschiene
- 5.1: erste Ausnehmung
- 5.2: zweite Ausnehmung
- 6: Pipettenträgerleiste
- 7: Ausnehmung
- 8: Pipettenhalter
- 8.1: oberer Teil
- 8.2: mittlerer Teil
- 8.3: unterer Teil
- 9: Vakuumkanal
- 9.1: oberes offenes Ende
- 9.2: unteres offenes Ende bzw. Ansaugöffnung
- 10: Übergangsbereich
- 11: Deckel
- 12: Durchlassöffnung
- 13: Vakuumsführungsöffnung
- 14: Kugelumlaufschlittenelement
- 14.1: erstes Kugellager
- 14.2: zweites Kugellager

- 14.3: erster Kugelsicherungsbügel
- 14.4: zweiter Kugelsicherungsbügel
- 15: Grundblockeinheit
- 16: Vakuumsversorgungsschiene
- 16.1: Vakuumanschlussöffnung
- 16.2: Vakuumversorgungsausnehmung
- 17: Spalt
- 18: Druckfeder
- 19: Anschlagring
- 20: Linearmotoreinheit
- 21: Vorschubelement
- 22: minimaler Auslenkzustand
- 23: maximaler Auslenkzustand
- 24: Abstandelement
- 25: Aufnahmebereich
- 26: Aufnahmeeinheit
- 27: Entnahmebereich
- 28: Entnahmeeinheit
- 29: Außenseite
- 30: Steg
- 31: Eckbereich
- 32: Rückführungseinheit
- 33: Steuereinheit
- 34: Lead-Frame
- RS: Rückführungsstrecke
- VS: Vakuumstrecke
- BS: Bearbeitungsstrecke
- FR: Förderrichtung
- RFR: Rückförderrichtung
- E: Eingang
- A: Ausgang
- LA: Längsachse
- D1: erster Durchmesser
- D2: zweiter Durchmesser
- D3: Öffnungsweite
- R1: erste Reihe
- R2: zweite Reihe
- R3: dritte Reihe
- R4: vierte Reihe
- P: Abstand bzw. Rastermaß
- TR: Rückführungszeitdauer
- t1: erster Förderzeitpunkt
- t2: zweiter Förderzeitpunkt
- t3: dritter Förderzeitpunkt
- t4: vierter Förderzeitpunkt

## Patentansprüche

1. Linearfördersystem zum hochgenauen Fördern von kleinen Bauelementen in einer Förderrichtung (FR), insbesondere von kleinen elektrischen Bauelementen (3) mit wenigstens einer Förderstrecke (2), bestehend aus einer Förderschiene (5) und darauf beweglich gelagerten Förderschlittenelementen (4.1 - 4.7), die jeweils eine Vielzahl von Transporteinheiten (8) zur Aufnahme jeweils eines Bauelementes (3) aufweisen, wobei am Eingang (E) der Förderstrecke (2) ein Aufnahmebereich (25) zur Aufnahme zumindest eines Bauelements (3) durch jeweils eine Transporteinheit (8) und am Ausgang (A) der linearen Förderstrecke (2) ein Entnahmebereich (27) zur Entnahme der Bauelemente (3) von den Transporteinheiten (8) vorgesehen ist,
**dadurch gekennzeichnet,**
**dass** eingangsseitig eine ein Vorschubelement (21) aufweisende Linearmotoreinheit (20) zum linearen Antrieb der Förderschlittenelemente (4.1 - 4.7) in Förderrichtung (FR) über das Vorschubelement (21) vorgesehen ist,
**dass** eine Rückführungseinheit (32) zur Rückführung zumindest eines Förderschlittenelementes (4.7) vom Ausgang (A) zum Eingang (E) der Förderstrecke (2) vorgesehen ist,
**dass** die Rückführungseinheit (32) zum ausgangsseitigen Aushängen aus der Förderschiene (5), zum Rückführen des ausgehängten Förderschlittenelementes (4.7) vom Ausgang (A) zum Eingang (E) und zum eingangsseitigen Einhängen des rückgeführten Förderschlittenelementes (4.7) in die Förderschiene (5) ausgebildet ist.

2. Linearfördersystem nach Anspruch 1, **dadurch gekennzeichnet, dass** das ausgangsseitige Aushängen eines Förderschlittenelementes (4.7) nach dem Verlassen des Entnahmebereiches (27) in Förderrichtung (FR) erfolgt und/oder dass das eingangsseitige Einhängen eines rückgeführten Förderschlittenelementes (4.7) in einen zwischen dem Vorschubelement (21) der Linearmotoreinheit (20) und dem Aufnahmebereich (25) befindlichen Abschnitt der Förderschiene (5) erfolgt.

3. Linearfördersystem nach Anspruch 1 oder 2, **dadurch gekennzeichnet, dass** das Vorschubelement (21) der Linearmotoreinheit (20) schrittweise getaktet in Förderrichtung (FR) ausfahrbar ist und jeweils zwischen zwei Vorschubschritten eine Förderpause aufweist und/oder dass das Ein- und das Aushängen des jeweiligen Förderschlittenelementes (4.7) aus bzw. in die Förderschiene (5) jeweils während einer Förderpause erfolgt.

4. Linearfördersystem nach einem der Ansprüche 1 bis 3, **dadurch gekennzeichnet, dass** durch das Vorschubelement (21) der Linearmotoreinheit (20) nahezu beliebige Auslenkpositionen zwischen einem minimalen Auslenkzustand (22) und einem maximalen Auslenkzustand (23) anfahrbar sind.

5. Linearfördersystem nach Anspruch 4, **dadurch gekennzeichnet, dass** das Einhängen des rückgeführten Förderschlittenelementes (4.7) in die Förderschiene (5) unmittelbar nach dem Umschalten der Linearmotoreinheit (20) von dem maximalen Auslenkzustand (23) in einen minimalen Auslenkzustand (22) erfolgt und/oder dass die für die Rückführung über die Rückführungsstrecke (RS) erforderliche Rückführungszeitdauer (TR) der von der Linearmotoreinheit (20) für die Auslenkung des Vorschubelementes (21) von der zum Aushängezeitpunkt vorliegenden Auslenkposition zum Erreichen des maximalen Auslenkungszustands (23) erforderlichen Förderzeitdauer entspricht und/oder dass die Bearbeitung der kleinen Bauelemente (3) auf der Förderstrecke (2) während zumindest einer Förderpause erfolgt.

6. Linearfördersystem nach einem der Ansprüche 1 bis 5, **dadurch gekennzeichnet, dass** pro Förderschlittenelement (4.1 bis 4.7) zumindest zwei auf der Förderschiene (5) beweglich lagerbare Kugelumlaufschlittenelemente (14) vorgesehen sind, wobei die Kugelumlaufschlittenelemente (14) zumindest ein erstes und zweite Kugellager (14.1, 14.2) aufweisen, welche in einer ersten bzw. zweiten Ausnehmung (5.1, 5.2) der Förderschiene (5) beweglich lagerbar sind.

7. Linearfördersystem nach Anspruch 6, **dadurch gekennzeichnet, dass** die zu den Kugelumlaufschlittenelementen (14) gewandte Außenseite (29) der Förderschiene (5) in dem zum Aus- und Einhängen der Förderschlittenelemente (4.1 bis 4.7) vorgesehenen Abschnitten der Förderschiene (5) zumindest teilweise abgeschrägt ist, und zwar derart, dass die zu den Kugelumlaufschlittenelementen (14) gewandte, durch die zweite Ausnehmung (5.2) gebildete seitliche Führung (30) entfällt.

8. Linearfördersystem nach einem der vorhergehenden Ansprüche, **dadurch gekennzeichnet, dass** die zur Aufnahme jeweils eines Bauelementes (3) an den Förderschlittenelementen (4.1 bis 4.7) vorgesehenen Transporteinheiten (8) als Pipettenhalter, insbesondere Vakuum-Pipettenhalter ausgebildet sind, wobei jedes Förderschlittenelement (4.1 bis 4.7) zumindest eine Pipettenträgerleiste (6) zur Aufnahme der Pipettenhalter (8) aufweist.

9. Linearfördersystem nach Anspruch 8, **dadurch gekennzeichnet, dass** die Pipettenhalter (8) in parallel zueinander angeordneten sowie senkrecht zur Förderrichtung (FR) verlaufenden Ausnehmungen (7) in der Pipettenträgerleiste (6) vorgesehen sind und/oder dass jeweils ein Pipettenhalter (8) einen entlang der Längsachse (LA) des Pipettenhalters (8) verlaufenden Vakuumkanal (9) aufweist und/oder dass eine Vakuumversorgungsschiene (16) in Förderrichtung (FR) parallel zur Förderschiene (5) angeordnet ist, die eine Vakuumanschlussöffnung (16.1) sowie eine Vakuumversorgungsausnehmung (16.2) aufweist.

10. Linearfördersystem nach Anspruch 9, **dadurch gekennzeichnet, dass** der Vakuumkanal (9) über eine im Pipettenhalter (8) vorgesehene Durchlassöffnung (12) und eine in der Pipettenträgerleiste (6) vorgesehene Vakuumführungsöffnung (13) mit einer Vakuumversorgungsausnehmung (16.2) der Vakuumversorgungsschiene (16) auf einer Vakuumstrecke (VS) in Verbindung steht und/oder dass ein Pipettenhalter (8) über eine Druckfeder (18) in der Pipettenträgerleiste (6) vorgespannt ist und/oder dass der Vakuumkanal (9) eines Pipettenhalters (8) ein oberes offenes Ende (9.1) und ein unteres offenes Ende (9.2) mit unterschiedlichen Durchmessern (D1, D2) aufweist.

11. Linearfördersystem nach Anspruch 10, **dadurch gekennzeichnet, dass** das obere offene Ende (9.1) über einen Deckel (11) luftdicht verschlossen ist und an dem unteren offenen Ende (9.2) über den im Vakuumkanal (9) ausgebildeten Unterdruck eine Ansaugöffnung zur Aufnahme eines kleinen Bauelements (3) ausgebildet ist.

12. Linearfördersystem nach einem der vorhergehenden Ansprüche, **dadurch gekennzeichnet, dass** die Förderschlittenelemente (4.1 bis 4.7) jeweils zumindest an der in Förderrichtung (FR) gerichteten Stirnseite ein Abstandselement (24) aufweisen, dessen Stirnfläche im Vergleich zur Oberfläche der Stirnseiten der Förderschlittenelemente (4.1 bis 4.7) reduziert ist und/oder dass der zwischen dem Vorschubelement (21) der Linearmotoreinheit (20) und dem Aufnahmebereich (25) befindliche Abschnitt der Förderschiene (5) in etwa der Länge des einzuhängenden rückgeführten Förderschlittenelementes (4.7) entspricht und/oder dass eine Steuereinheit (33) zur Steuerung der Linearmotoreinheit (20) und/oder der Rückführungseinheit (32) vorgesehen ist.

13. Verfahren zum hochgenauen Fördern von kleinen Bauelementen (3), insbesondere von kleinen elektrischen Bauelementen, bei dem kleine Bauelemente (3) entlang wenigstens einer linearen Förderstrecke (2), die eine Förderschiene (5) und darauf beweglich gelagerte Förderschlittenelemente (4.1 bis 4.7) aufweist, von einem eingangsseitigen Aufnahmebereich (25) zu einem ausgangsseitigen Entnahmebereich (27) gefördert werden, wobei die kleinen Bauelemente (3) im Aufnahmebereich (25) anhand von mehreren an den Förderschlittenelementen (4.1 bis 4.7) vorgesehenen Transporteinheiten (8) aufgenommen, entlang der Förderstrecke (2) transportiert und im Entnahmebereich (27) von den Transporteinheiten (8) entnommen werden,
**dadurch gekennzeichnet,**
**dass** die aneinander anschließenden Förderschlittenelemente (4.1 bis 4.7) auf der Förderschiene (5) mittels eines Vorschubelementes (21) einer eingangsseitig vorgesehen Linearmotoreinheit (20) in Förderrichtung (FR) gefördert werden,
**dass** ausgangsseitig jeweils ein Förderschlittenelement (4.7) von der Förderschiene (5) ausgehängt wird,
**dass** das ausgehängte Förderschlittenelement (4.7) über eine Rückführungsstrecke (RS) rückgeführt wird und
**dass** eingangsseitig das rückgeführte Förderschlittenelement (4.7) in die Förderschiene (5) eingehängt wird.

14. Verfahren nach Anspruch 12, **dadurch gekennzeichnet, dass** ausgangsseitig jeweils das den Entnahmebereich (27) in Förderrichtung (FR) verlassende Förderschlittenelement (4.7) von der Förderschiene (5) ausgehängt wird und/oder dass das rückgeführte Förderschlittenelement (4.7) in einen zwischen dem Vorschubelement (21) der Linearmotoreinheit (20) und dem Aufnahmebereich (25) befindlichen Abschnitt der Förderschiene (5) eingehängt wird und/oder dass das Ein- und das Aushängen des jeweiligen Förderschlittenelementes (4.7) aus bzw. in die Förderschiene (5) jeweils während einer Förderpause der Förderstrecke (2) durchgeführt werden.

15. Verfahren nach Anspruch 13 oder 14, **dadurch gekennzeichnet, dass** das rückgeführte Förderschlittenelement (4.7) in die Förderschiene (5) unmittelbar nach dem Umschalten der Linearmotoreinheit (20) von einem maximalen Auslenkzustand (23) in einen minimalen Auslenkzustand (22) eingehängt wird und/oder dass die für die Rückführung über die Rückführungsstrecke (RS) erforderliche Rückführungszeitdauer (TR) der von der Linearmotoreinheit (20) für die Auslenkung des Vorschubelementes (21) von der zum Aushängezeitpunkt vorliegenden Auslenkposition zum Erreichen des maximalen Auslenkungszustands (23) erforderlichen Förderzeitdauer entspricht und/oder dass während der Bearbeitung der kleinen Bauelemente (3) auf der Bearbeitungsstrecke (BS) die Linearmotoreinheit (20) vom maximalen Auslenkzustand (23) in den minimalen Auslenkzustand (22) umgeschaltet wird.

16. Verfahren nach Anspruch 15, **dadurch gekennzeichnet, dass** zum Umschalten der Linearmotoreinheit (20) vom maximalen Auslenkzustand (23) in den minimalen Auslenkzustand (22) das Vorschubelement (21) entgegensetzt zur Förderrichtung (FR) nahezu vollständig in die Linearmotoreinheit (20) eingefahren wird.

## Claims

1. Linear conveyor system for the high-precision conveyance of small component parts in one conveyor direction (FR), more particularly of small electrical component parts (3), with at least one conveyor path (2), consisting of a conveyor rail (5) and conveyor slide elements (4.1- 4.7) mounted movable thereon of which each has a number of transport units (8) for receiving one component part (3) each, wherein at the input (E) to the conveyor path (2) there is a pick-up area (25) for receiving at least one component part (3) through each one transport unit (8) and at the output (A) of the linear conveyor path (2) there is a delivery area (27) for removing the component parts (3) from the transport units (8) **characterised in that** at the input side there is a linear motor unit (20) with forward feed element (21) for linearly driving the conveyor slide elements (4.1 - 4.7) in the conveyor direction (FR) via the forward feed element (21), that a return unit (32) is provided for returning at least one conveyor slide element (4.7) back from the output (A) to the input (E) of the conveyor path (2), that the return unit (32) is designed for disengagement from the conveyor rail (5) at the output side, for returning the disengaged conveyor slide element (4.7) from the output (A) to the input (E) and for hanging the returned conveyor slide element (4.7) back into the conveyor rail (5) at the input side.

2. Linear conveyor system according to claim 1 **characterised in that** the disengagement of a conveyor slide element (4.7) at the output side takes place after leaving the delivery area (27) in the conveyor direction (FR) and/or that the engagement of a returned conveyor slide element (4.7) on the input side takes place in a section of the conveyor rail (5) which is located between the forward feed element (21) of the linear motor unit (20) and the pick-up area (25).

3. Linear conveyor system according to claim 1 or 2 **characterised in that** the forward feed element (21) of the linear motor unit (20) is moved synchronized step by step in the conveyor direction (FR) and has a conveyor pause between each two feed steps and/or that the engagement and disengagement of each relevant conveyor slide element (4.7) in and out of the conveyor rail (5) takes place each time during a conveyor pause.

4. Linear conveyor system according to one of claims 1 to 3 **characterised in that** practically any deflection positions between a minimum deflection state (22) and a maximum deflection state (23) can be reached by the forward feed element (21) of the linear motor unit (20).

5. Linear conveyor system according to claim 4 **characterised in that** the engagement of the returned conveyor slide element (4.7) in the conveyor rail (5) takes place immediately after switching over the linear motor unit (20) from the maximum deflection state (23) into a minimum deflection state (22) and/or that the return period (TR) required for returning over the return stretch (RS) corresponds to the conveyor period required by the linear motor unit (20) for deflecting the forward feed element (21) from the deflection position existing for the disengagement time point for reaching the maximum deflection state (23) and/or that the finishing of the small component parts (3) on the conveyor path (2) takes place during at least one conveyor pause.

6. Linear conveyor system according to one of claims 1 to 5 **characterised in that** for each conveyor slide element (4.1 to 4.7) there are at least two ball return carriage elements (14) which can be mounted movable on the conveyor rail (5) wherein the ball return carriage elements (14) have at least a first and second ball bearing (14.1, 14.2) which can be mounted movable in a first and second recess (5.1, 5.2) respectively of the conveyor rail (5).

7. Linear conveyor system according to claim 6 **characterised in that** the outside (29) of the conveyor rail (5) facing the ball return carriage elements (14) in the sections of the conveyor rail (5) provided for the disengagement and engagement of the conveyor slide elements (4.1 to 4.7) is inclined at least in part, namely so that the lateral guide (30) formed by the second recess (5.2) and facing the ball return carriage elements (14) is omitted.

8. Linear conveyor system according to any one of the preceding claims **characterised in that** the transport units (8) each provided on the conveyor slide elements (4.1 to 4.7) for receiving one component part (3) each are designed as pipette holders, more particularly vacuum pipette holders wherein each conveyor slide element (4.1 to 4.7) has at least one pipette support strip (6) for holding the pipette holders (8).

9. Linear conveyor system according to claim 8 **characterised in that** the pipette holders (8) are provided in recesses (7) arranged parallel to one another and running perpendicular to the conveyor direction (FR) in the pipette support strip (6) and/or that each one pipette holder (8) has a vacuum channel (9) running along the longitudinal axis (LA) of the pipette holder (8) and/or that a vacuum supply rail (16) is mounted in the conveyor direction (FR) parallel to the conveyor rail (5) which has a vacuum connection opening (16.1) as well as a vacuum supply recess (16.2).

10. Linear conveyor system according to claim 9 **characterised in that** the vacuum channel (9) is connected to a vacuum supply recess (16.2) of the vacuum supply rail (16) on a vacuum stretch (VS) via a through aperture (12) in the pipette holder (8) and via a vacuum guide aperture (13) in the pipette support strip (6), and/or that a pipette holder (8) is pretensioned via a compression spring (18) in the pipette support strip (6) and/or that the vacuum channel (9) of a pipette holder (8) has an upper open end (9.1) and a lower open end (9.2) of different diameters (D1, D2).

11. Linear conveyor system according to claim 10 **characterised in that** the upper open end (9.1) is closed air-tight by a cover (11) and a suction intake opening for picking up a small component part (3) is formed at the lower open end (9.2) via the underpressure formed in the vacuum channel (9).

12. Linear conveyor system according to one of the preceding claims **characterised in that** the conveyor slide elements (4.1 to 4.7) each have at least on the end side directed in the conveyor direction (FR) a spacer element (24) whose end surface area is reduced compared with the surface area of the end sides of the conveyor slide elements (4.1 to 4.7) and/or that the section of the conveyor rail (5) located between the forward feed element (21) of the linear motor unit (20) and the pick-up area (25) corresponds roughly to the length of the returned conveyor slide element (4.7) which is to be engaged and/or that a control unit (33) is provided for controlling the linear motor unit (20) and/or the return unit (32).

13. Method for the high-precision conveyance of small component parts (3), more particularly of small electrical component parts, in which small component parts (3) are conveyed along at least one linear conveyor path (2) which has a conveyor rail (5) and conveyor slide elements (4.1 to 4.7) mounted movable thereon, from a pick-up area (25) at the input side to a delivery area (27) at the output side, wherein the small component parts (3) are picked up in the pick-up area (25) by means of several transport units (8) provided on the conveyor slide elements (4.1 to 4.7), are transported along the conveyor path (2) and are removed in the delivery area (27) from the transport units (8) **characterised in that** the conveyor slide elements (4.1 to 4.7) adjoining one another are conveyed on the conveyor rail (5) in the conveyor direction (FR) by means of a forward feed element (21) of a linear motor unit (20) provided at the input side, that at the output side each one conveyor slide element (4.7) is disengaged from the conveyor rail (5), that the disengaged conveyor slide element (4.7) is returned over a return stretch (RS) and that at the input side the returned conveyor slide element (4.7) is engaged back into the conveyor rail (5).

14. Method according to claim 12 **characterised in that** at the output side each conveyor slide element (4.7) leaving the delivery area (27) in the conveyor direction (FR) is disengaged from the conveyor rail (5) and/or that the returned conveyor slide element (4.7) is engaged in a section of the conveyor rail (5) located between the forward feed element (21) of the linear motor unit (20) and the pick-up area (25) and/or that the engagement and disengagement of each relevant conveyor slide element (4.7) in and out from the conveyor rail (5) is carried out each time during a conveyor pause of the conveyor path (2).

15. Method according to claim 13 or 14 **characterised in that** the returned conveyor slide element (4.7) is engaged in the conveyor rail (5) immediately after the linear motor unit (20) is switched over from a maximum deflection state (23) into a minimum deflection state (22) and/or that the return period (TR) required for the return over the return stretch (RS) corresponds to the conveyor period required by the linear motor unit (20) for the deflection of the forward feed element (21) from the deflection position present for the disengagement time point for reaching the maximum deflection state (23) and/or that during the finishing of the small component parts (3) on the finishing stretch (BS) the linear motor unit (20) is switched over from the maximum deflection state (23) into the minimum deflection state (22).

16. Method according to claim 15 **characterised in that** for the switching of the linear motor unit (20) over from the maximum deflection state (23) into the minimum deflection state (22) the forward feed element (21) is driven opposite the conveyor direction (FR) practically completely into the linear motor unit (20).

## Revendications

1. Système de transport linéaire pour le transport de haute précision de petits composants dans un sens de transport (FR), en particulier de petits composants électriques (3), comprenant au moins une section de transport (2), constituée d'un rail de transport (5) sur lequel sont montés de manière mobile des coulisseaux de transport (4.1 à 4.7), qui présentent une pluralité d'unités de transport (8) pour recevoir, respectivement, un composant (3), dans lequel il est prévu, à l'entrée (E) de la section de transport (2), une zone de réception (25) pour recevoir au moins un composant (3) à travers, respectivement, une unité de transport (8) et, à la sortie (A) de la section de transport linéaire (2), une zone de retrait (27) pour retirer les composants (3) des unités de transport (8),
**caractérisé en ce que,**
du côté entrée, il est prévu une unité à moteur linéaire (20) présentant un élément d'avancement (21) pour l'entraînement linéaire des coulisseaux de transport (4.1 à 4.7) dans le sens de transport (FR) via l'élément d'avancement (21), il est prévu une unité de renvoi (32) pour renvoyer au moins un coulisseau de transport (4.7) de la sortie (A) à l'entrée (E) de la section de transport (2), et
l'unité de renvoi (32) est conformée pour décrocher du rail de transport (5), du côté sortie, renvoyer le coulisseau de transport décroché (4.7) de la sortie (A) à l'entrée (E) et accrocher, du côté entrée, le coulisseau de transport renvoyé (4.7) dans le rail de transport (5).

2. Système de transport linéaire selon la revendication 1, **caractérisé en ce que** le décrochage du côté sortie d'un coulisseau de transport (4.7) se fait après avoir quitté la zone de retrait (27) dans le sens de transport (FR) et/ou l'accrochage du côté entrée d'un coulisseau de transport renvoyé (4.7) se fait dans une section du rail de transport (5) se trouvant entre l'élément d'avancement (21) de l'unité à moteur linéaire (20) et la zone de réception (25).

3. Système de transport linéaire selon la revendication 1 ou 2, **caractérisé en ce que** l'élément d'avancement (21) de l'unité à moteur linéaire (20) est déplaçable progressivement de manière cadencée dans le sens de transport (FR) et présente, respectivement, entre deux étapes d'avancement une pause de transport et/ou l'accrochage et le décrochage du coulisseau de transport respectif (4.7) hors du rail de transport (5) ou dans celui-ci se produisent, respectivement, pendant une pause de transport.

4. Système de transport linéaire selon l'une quelconque des revendications 1 à 3, **caractérisé en ce que** l'élément d'avancement (21) de l'unité à moteur linéaire (20) permet de démarrer dans pratiquement n'importe quelles positions de déviation entre un état de déviation minimale (22) et un état de déviation maximale (23).

5. Système de transport linéaire selon la revendication 4, **caractérisé en ce que** l'accrochage du coulisseau de transport renvoyé (4.7) a lieu dans le rail de transport (5) directement après le passage de l'unité de moteur linéaire (20) de l'état de déviation maximale (23) à l'état de déviation minimale (22) et/ou l'intervalle de temps de renvoi (TR) requis pour le renvoi via la section de renvoi (RS) correspond à l'intervalle de temps de transport requis par l'unité à moteur linéaire (20) pour la déviation de l'élément d'avancement (21) de la position de déviation existant au moment du décrochage pour atteindre l'état de déviation maximale (23) et/ou l'usinage des petits composants (3) sur la section de transport (2) se fait pendant au moins une pause de transport.

6. Système de transport linéaire selon l'une quelconque des revendications 1 à 5, **caractérisé en ce que** chaque coulisseau de transport (4.1 à 4.7) comprend au moins deux coulisseaux à recirculation de billes (14) qui peuvent être montés de manière mobile sur le rail de transport (5), dans lequel les coulisseaux à recirculation de billes (14) présentent au moins un premier et un deuxième roulements à billes (14.1, 14.2), qui peuvent être montés de manière mobile dans un premier ou un deuxième évidement (5.1, 5.2) du rail de transport (5).

7. Système de transport linéaire selon la revendication 6, **caractérisé en ce que** le côté externe (29) du rail de transport (5) tourné vers les coulisseaux à recirculation de billes (14) est au moins en partie biseauté dans les sections du rail de transport (5) prévues pour le décrochage et l'accrochage des coulisseaux de transport (4.1 à 4.7) et ce, de manière à supprimer le guidage latéral (30) tourné vers les coulisseaux à recirculation de billes (14), formé par le deuxième évidement (5.2).

8. Système de transport linéaire selon l'une quelconque des revendications précédentes, **caractérisé en ce que** les unités de transport (8) prévues pour la réception, respectivement, d'un composant (3) sur les coulisseaux de transport (4.1 à 4.7) présentent la forme d'un support de pipette, en particulier d'un support de pipette à vide, dans lequel chaque coulisseau de transport (4.1 à 4.7) présente au moins une latte de supports de pipettes (6) pour recevoir les supports de pipettes (8).

9. Système de transport linéaire selon la revendication 8, **caractérisé en ce que** les supports de pipettes (8) sont disposés dans des évidements (7) agencés parallèlement l'un à l'autre ainsi que perpendiculairement à la direction de transport (FR) dans la latte de supports de pipettes (6) et/ou, respectivement, un support de pipette (8) présente un canal à vide (9) s'étendant le long de l'axe longitudinal (LA) du support de pipette (8) et/ou un rail d'alimentation à vide (16) est agencé dans la direction de transport (FR) parallèlement au rail de transport (5) qui présente une ouverture de raccordement au vide (16.1) ainsi qu'un évidement d'alimentation à vide (16.2).

10. Système de transport linéaire selon la revendication 9, **caractérisé en ce que** le canal à vide (9) communique par une ouverture de passage (12) ménagée dans le support de pipette (8) et une ouverture de guidage à vide (13) ménagée dans la latte de supports de pipettes (6) avec un évidement d'alimentation à vide (16.2) du rail d'alimentation à vide (16) sur une section à vide (VS) et/ou un support de pipette (8) est précontraint par un ressort de pression (18) dans la latte de supports de pipettes (6) et/ou le canal à vide (9) d'un support de pipette (8) présente une extrémité supérieure ouverte (9.1) et une extrémité inférieure ouverte (9.2) de différents diamètres (D1, D2).

11. Système de transport linéaire selon la revendication 8, **caractérisé en ce que** l'extrémité supérieure ouverte (9.1) est fermée de manière étanche à l'air via un couvercle (1.1) et l'extrémité ouverte inférieure (9.2) présente une ouverture d'aspiration pour recevoir un petit composant (3) en raison de la dépression formée dans le canal à vide (9).

12. Système de transport linéaire selon l'une quelconque des revendications précédentes, **caractérisé en ce que** les coulisseaux de transport (4.1 à 4.7) présentent, respectivement, au moins sur le côté frontal dirigé dans le sens de transport (FR), un élément écarteur (24) dont la surface frontale est réduite par rapport à la surface des côtés frontaux des coulisseaux de transport (4.1 à 4.7) et/ou la section du rail de transport (5) se trouvant entre l'élément d'avancement (21) de l'unité à moteur linéaire (20) et la zone de réception (25) correspond approximativement à la longueur du coulisseau de transport renvoyé à accrocher (4.7) et/ou il est prévu une unité de commande (33) pour commander l'unité à moteur linéaire (20) et/ou l'unité de renvoi (32).

13. Procédé pour le transport de haute précision de petits composants (3), en particulier de petits composants électriques, dans lequel de petits composants (3) sont transportés le long d'au moins une section de transport linéaire (2), qui présente un rail de transport (5) sur lequel des coulisseaux de transport (4.1 à 4.7) sont montés de manière mobile, d'une zone de réception du côté entrée (25) à une zone de retrait du côté sortie (27), dans lequel les petits composants (3) sont reçus dans la zone de réception (25) à l'aide de plusieurs unités de transport (8) agencées sur les coulisseaux de transport (4.1 à 4.7), transportés le long de la section de transport (2) et retirés des unités de transport (8) dans la zone de retrait (27),
**caractérisé en ce que**
les coulisseaux de transport adjacents les uns aux autres (4.1 à 4.7) sont transportés sur le rail de transport (5) à l'aide d'un élément d'avancement (21) d'une unité à moteur linéaire prévue du côté entrée (20) dans le sens de transport (FR), du côté sortie, respectivement, un coulisseau de transport (4.7) est décroché du rail de transport (5),
le coulisseau de transport décroché (4.7) est renvoyé via une section de renvoi (RS) et,
du côté entrée, le coulisseau de sortie (4.7) est accroché dans le rail de transport (5).

14. Procédé selon la revendication 12, **caractérisé en ce que,** du côté sortie, le coulisseau de transport (4.7) quittant la zone de retrait (27) dans le sens de transport (FR) est décroché du rail de transport (5) et/ou le coulisseau de transport renvoyé (4.7) est accroché dans une section du rail de transport (5) se trouvant entre l'élément d'avancement (21) de l'unité à moteur linéaire (20) et la zone de réception (25) et/ou l'accrochage et le décrochage du coulisseau de transport respectif (4.7) hors du rail de transport ou dans celui-ci et ou sont réalisés respectivement pendant une pause de transport de la section de transport (2).

15. Procédé selon la revendication 13 ou 14,
**caractérisé en ce que** le coulisseau de transport renvoyé (4.7) est accroché dans le rail de transport (5) directement après le passage de l'unité à moteur linéaire (20) d'un état de déviation maximale (23) à un état de déviation minimale (22) et/ou l'intervalle de temps de renvoi (TR) requis pour le renvoi sur la section de renvoi (RS) correspond à l'intervalle de temps de transport requis par l'unité à moteur linéaire pour la déviation de l'élément d'avancement (21) de la position de déviation existant au moment du décrochage pour atteindre l'état de déviation maximale (23) et/ou, pendant l'usinage des petits composants (3) sur la section d'usinage (BS), l'unité à moteur linéaire (20) passe de l'état de déviation maximale (23) à l'état de déviation minimale (22).

16. Procédé selon la revendication 15, **caractérisé en ce que,** pour faire passer l'unité à moteur linéaire (20) de l'état de déviation maximale (23) à l'état de déviation minimale (22), l'élément d'avancement (21) est rentré presque entièrement, inversement au sens de transport (FR), dans l'unité à moteur linéaire (20).
